# EUROPEAN PATENT SPECIFICATION

(11) **EP 2 376 584 B1**
(45) Date of publication and mention of the grant of the patent: **16.07.2014**
(21) Application number: 09832279.5
(22) Date of filing: 19.10.2009
(51) Int. Cl.: C09D 183/04, G03F 7/11, H01L 21/30, C09D 183/06

(54) **WET-ETCHABLE ANTIREFLECTIVE COATINGS**
NASSÄTZBARE ANTIREFLEXBESCHICHTUNGEN
REVÊTEMENTS ANTIRÉFLÉCHISSANTS GRAVABLES PAR VOIE HUMIDE

(30) Priority: 10.12.2008 US 121357 P
(43) Date of publication of application: 19.10.2011
(73) Proprietor: Dow Corning Corporation, Midland, Michigan 48686-0994 (US)
(72) Inventor: FU, Peng-Fei, Midland MI 48642 (US); MOYER, Eric, Midland MI 48642 (US); YEAKLE, Craig, Midland MI 48640 (US)
(74) Representative: Thomson, James B.
(86) International application number: PCT/US2009/061130
(87) International publication number: WO 2010/068337

(56) References cited:
- EP-A1- 1 586 603
- EP-A1- 1 867 681
- EP-A2- 1 788 011
- EP-A2- 1 845 132
- WO-A2-2005/007747
- WO-A2-2007/094848
- WO-A2-2007/094849
- WO-A2-2009/111121

## Description

### BACKGROUND

With the continuing demand for smaller feature sizes in the semiconductor industry, 193 nm optical lithography has emerged very recently as the technology to produce devices with sub-100 nm features. The use of such a shorter wavelength of light requires the bottom antireflective coating (BARC) to reduce the reflection on substrate and dampen the photoresist swing cure by absorbing light that has passed though the photoresist. Commercially available antireflective coatings consist of both organic and inorganic based materials. Typically, the inorganic ARC, which exhibits good etch resistance, is CVD based and is subject to all the integration disadvantage of extreme topography; on the other hand, the organic ARC materials are applied by spin-on process and have excellent fill and planarization properties, but suffer from poor etch selectivity to organic photoresists. As a result, a material that offers the combined advantages of organic and inorganic ARC is highly desired.

In this regards, we have recently discovered that certain phenyl-hydride based silsesquoxane resins exhibit excellent antireflective coating properties for 193 nm light. Although Bottom Anti Reflective Coatings (BARC) materials can effectively reduce the reflection of activating radiation, removal of BARC materials without damaging the overlying photoresist and/or the underlying substrate has been very challenging. The typical process to remove BARC is by a plasma etch process. Plasma etch often cause thinning of a photoresist layer. As a result, the patterns on the photoresist layer may be destroyed or becomes not transferable to the substrate layer. Plasma etch may also cause damage to the substrate thereby affecting the performance of the final device. What is more, the additional etch step for removing the BARC material increases cost and process complication in photolithographic practice.

One solution to this problem is to use a wet-developable BARCs. After the photoresist layer is exposed through a patterned mask, the exposed areas become wet-developable and are subsequently removed with an aqueous developer to reveal the desired trench and/or hole patterns. The underlying wet-developable BARC coating are simultaneously removed during this developing step, thus eliminating the additional plasma etching step. Organic wet-developable ARC materials have been based on polyamic acids. This type of BARCs that depends on the partial formation of polyimide from polyamic acid to obtain the desired dissolution properties, have a very limited temperature window and are difficult to be controlled effectively. Other organic BARC containing at least one unit with an acid labile group, a lactone, or a maleimide. However, none of these wet-developable organic BARC materials has the required dry-etch resistance as a BARC for subsequent pattern transfer

This invention pertains to wet-etchable antireflective coating layer for photolithography produced from carboxy functional silsesquioxane resins. The carboxy functional silsesquioxane resins form excellent spin-on film and are resistant to organic solvents such as PGMEA, 2-heptonene, but are wet-etchable when cured at 250°C or below. In addition the ARCs produced from the carboxyl function silsesquioxane resins show excellent dry-etch resistance.

WO 2007/094848 discloses antireflective coatings comprising (i) a silsesquioxane resin having the formula (PhSiO_{(3-x)/2}(OH)ₓ)ₘ (HSiO_{(3-x)/2}(OH)ₓ)ₙ (MeSiO_{(3-x)/2}(OH)ₓ)ₚ where Ph is a phenyl group; Me is a methyl group; x has a value of 0,1 or 2; m has a value of 0.01 to 0.99; n has a value of 0.01 to 0.99; p has a value of 0.01 to 0.99; and m + n + p ≈ 1; (ii) a polyethylene oxide fluid; and (iii) a solvent.

WO 2007/094849 discloses silsesquioxane resins useful in forming antireflective coatings, the silsesquioxane resins having the formula (PhSiO_{(3-x)/2}(OH)ₓ)ₘ (HSiO_{(3-x)/2}(OH)ₓ)ₙ (MeSiO_{(3-x)/2}(OH)ₓ)ₚ (RSiO_{(3-x)/2}(OH)ₓ)_{q} where Ph is a phenyl group; Me is a methyl group; R is a polyethylene oxide group; x has a value of 0,1 or 2; m has a value of 0.01 to 0.99; n has a value of 0.01 to 0.99; p has a value of 0.01 to 0.99; q has a value of 0.01 to 0.50; and m + n + p + q ≈ 1.

WO 2009/111121 is a document falling under Article 54(3) EPC which discloses silsesquioxane resins useful in antireflective coatings, wherein the silsesquioxane resin is comprised of the units (Ph(CH₂)ᵣSiO_{(3-x)/2}(OR')ₓ)ₘ (HSiO_{(3-x)/2}(OR')ₓ)ₙ (MeSiO_{(3-x)/2}(OR')ₓ)ₒ (RSiO_{(3-x)/2}(OR')ₓ)ₚ (R¹SiO_{(3-x)/2}(OR')ₓ)_{q} where Ph is a phenyl group; Me is a methyl group; R' is a hydrogen atom or a hydrocarbon group having from 1 to 4 carbon atoms; R is selected from a hydroxyl producing group; and R¹ is selected from substituted phenyl groups, ester groups, polyether groups, mercapto groups and reactive or curable organic functional groups; r has a value of 0, 1, 2, 3 or 4; x has a value of 0, 1 or 2; wherein in the resin m has a value of 0 to 0.95; n has a value of 0.05 to 0.95; o has a value of 0.05 to 0.95; p has a value of 0.05 to 0.5; q has a value of 0 to 0.5; and m + n + o + p + q ≈ 1.

### BRIEF SUMMARY

This invention pertains to wet-etchable antireflective coatings produced from carboxy functional silsesquioxane resins consisting of the units

(Ph(CH₂)ᵣSiO_{(3-x)/2}(OR')ₓ)ₘ

(HSiO_{(3-x)/2}(OR')ₓ)ₙ

(MeSiO_{(3-x)/2}(OR')ₓ)ₒ

(RSiO_{(3-x)/2}(OR')ₓ)ₚ

(R¹SiO_{(3-x)/2}(OR')ₓ)_{q}

where Ph is a phenyl group, Me is a methyl group; R' is hydrogen atom or a hydrocarbon group having from 1 to 4 carbon atoms; R is a carboxylic acid forming group optionally with an acid group according to claim 1, with the proviso that there is a sufficient amount of carboxylic acid groups to make the resin wet-etchable after cure; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.95; n has a value of 0.05 to 0.95; o has a value of 0 to 0.95; p has a value of 0.05 to 0.5; q has a value of 0 to 0.95; and m + n + 0 + p + q ≈ 1. When these resins are used in antireflective coatings, they can be cured without any additive at temperatures at and below 250°C within 1 minute. The cured films exhibit excellent solvent resistance (i.e. PGMEA). The cured films are wet-etchable and can be readily removed using alkaline developers such as TMAH and/or strippers such as fluoride based stripping solutions (e.g. NE-89 and CCT-1.)

### BRIEF DESCRIPRTION OF THE DRAWINGS

Figure 1 shows a traditional dry patterning process using a resist layer and an antireflective coating layer.
Figure 2 shows a wet patterning process using a resist layer and the antireflective coating described herein.

### DETAILED DESCRPTION

The silsesquioxane resins useful in forming the antireflective coating are consisting of the units

(Ph(CH₂)ᵣSiO_{(3-x)/2}(OR')ₓ)ₘ

(HSiO_{(3-x)/2}(OR')ₓ)ₙ

(MeSiO_{(3-x)/2}(OR')ₓ)ₒ

(RSiO_{(3-x)/2}(OR')ₓ)ₚ

(R¹SiO_{(3-x)/2}(OR')ₓ)_{q}

where Ph is a phenyl group, Me is a methyl group; R' is hydrogen atom or a hydrocarbon group having from 1 to 4 carbon atoms; R is according to claim 1; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.90; n has a value of 0.05 to 0.99; o has a value of 0 to 0.95; p has a value of 0.01 to 0.5; q has a value of 0 to 0.5; and m + n + o + p + q ≈ 1. Typically m has a value of 0.05 to 0.25, alternatively 0.05 to 0.15. Typically n has a value of 0.15 to 0.80, alternatively 0.2 to 0.75. Typically o has a value of 0.25 to 0.80, alternatively 0.4 to 0.75. Typically p has a value of 0.015 to 0.35, alternatively 0.025 to 0.25. Typically q has a value of 0 to 0.15, alternatively 0 to 0.1.

R' is independently a hydrogen atom or hydrocarbon group having 1 to 4 carbon atoms. R' may be exemplified by H, methyl, ethyl, propyl, iso-propyl and butyl.

In the resin R is a carboxylic acid forming group optionally together with a carboxylic acid group, with a proviso that there is a sufficient amount of carboxylic acid groups to make the resin wet etchable after cure in the absence of thermal acid generators and/or photo-acid generators. By wet-etchable it is meant that the cured coating is removed with alkaline developers and/or etching solutions. Examples of carboxylic acid groups are those of the general formula - R²C(O)OH where R² is selected from alkylene groups having 1 -10 carbon atoms. Examples of carboxylic acid forming groups are those of the general formula -R²C(O)OR³ where R is selected from alkylene groups having 1 -10 carbon atoms, and R³ is a protecting group. Protecting groups are organic or silyl groups that cleave under acidic conditions to yield the corresponding carboxylic acid group. Protecting groups may be exemplified, but not limited, by t-butyl, trimethylsilyl, anhydride groups, methylthiomethyl ester, benzyloxymethyl ester, diphenylmethyl ester, p-methoxybenzyl ester, and others. Many of the protecting groups are described in "Protective groups in organic synthesis" by Greene and Wuts, 3rd Edition, page369-453.

R¹ is selected from substituted phenyl groups, ester groups, mercapto groups, sulfur-containing organic functional groups, aryl sulphonic ester groups, and reactive or curable organic functional groups. Substituted phenyl groups contain at least one HO-, MeO-, Me-, Et- Cl- and/or other substituents. Ester groups may be any organic substituent containing at least one ester functionality. Examples of ester groups useful herein are -(CH₂)₂-O-C(O)Me and -(CH₂)₂-C(O)-OMe. Polyether groups are an organic substituent having hydrocarbon units linked through oxygen atom, represented, but not limited, by the following structure: -
(CH₂)ₐ[O(CH₂)_{b}]_{c}OR⁴, wherein a = 2 to 12; b = 2 to 6; c = 2 to 200; R⁴ = H, alkyl, or other organic groups. Mercapto groups have the general formula HS(CH₂)_{d}-where d has a value of 1- 18, such as mercaptopropyl, mercaptoethyl, and mercaptomethyl. Aryl sulfonic ester groups have the formula R⁵O-SO₂-Ph-(CH₂)r- where R⁵ is a hydrogen atom, an aliphatic group or an aromatic group and r has a value of 0, 1, 2, 3, or 4. Aryl sulfonic ester groups may be exemplified by, but not limited to HO-SO₂-Ph-(CH₂)ᵣ- or (CH₃)₂CHO-SO₂-Ph-(CH₂)ᵣ-. Reactive or curable organic functional groups may be exemplified by, but not limited to alkenyl groups such as vinyl and allyl; epoxy groups such as glycidoxypropyl group and epoxycyclohexane group, acrylate groups such as methacryoxypropyl groups, acryloxypropyl, and others.

The typical method for producing the carboxy functional silsesquioxane resin involves the hydrolysis and condensation of the appropriate halo or alkoxy silanes. One example is the hydrolysis and condensation of a mixture of phenyltrichlorsilane, trichlorosilane, a silane having a carboxylic acid group and/or carboxylic acid forming group, methyltrichlorosilane and optionally other organofunctional trichlorosilanes. By this method it is possible that residual -OH and/or -OR' will remain in the silsesquioxane resin as a result of incomplete hydrolysis or condensation. If the total amount of units in the silsesquioxane resin containing -OR' groups, exceed 40 mole% then gellation and instability of the resin may occur. Typically the silsesquioxane resin contains 6 to 38 mole% of units containing -OR' groups, alternatively less than 5 mole%, alternatively less than 1 mole%.

The silsesquioxane resin has a weight average molecular weight (Mw) in the range of 500 to 200,000 alternatively in the range of 500 to 100,000, alternatively in the range of 700 to 30,0000 as determined by gel permeation chromatography employing RI detection and polystyrene standards.

A method for preparing a siloxane resin comprises reacting water, HSiX₃, RSiX₃, and optionally MeSiX₃, PhSiX₃, ors R¹SiX₃ in an organic solvent, where X is a hydrolyzable group independently selected from Cl, Br, CH₃CO₂-, an alkoxy group -OR', or other hydrolyzable groups. The silanes useful herein can be exemplified by, but not limited to, HSi(OEt)₃, HSiCl₃, PhCH₂CH₂SiCl₃ , and PhSiCl₃, MeSi(OMe)₃, MeSiCl₃, R¹SiCl₃ and R¹Si(OMe₃)₃ where R¹ is as defined above, Me represents a methyl group, Et represents an ethyl group and Ph represents a phenyl group.

Silanes having a carboxylic acid group and/or carboxylic acid forming group that may be used in the preparation of the silsesquioxane resin, may be exemplified by, but not limited to,

(MeO)₃Si-(CH₂)₂-COO^{t}Bu

(MeO)₃Si-(CH₂)_{d}-(OCH₂CH₂)ₑ-COO^{t}Bu

(MeO)₃Si-(CH₂)₂-COO-SiMe₃

(MeO)₃Si-(CH₂)_{d}-(OCH₂CH₂)ₑ-COO-SiMe₃

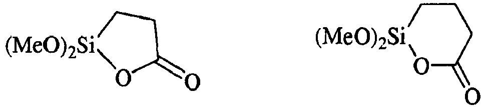

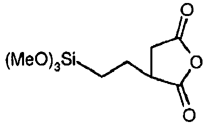

and 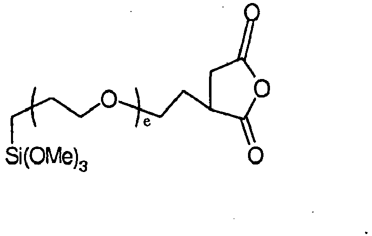 wherein Me is a methyl group, ^{t}Bu is a t-butyl group, g has a value of 2 or 3 and h has a value of 1 to 10.

The amount of water in the reaction is typically in the range of 0.5 to 2 moles water per mole of X groups in the silane reactants, alternatively 0.5 to 1.5 moles per mole of X groups in the silane reactants.

The time to form the silsesquioxane resin is dependent upon a number of factors such as the temperature, the type and amount of silane reactants, and the amount of catalyst, if present. It is preferred to carry out the reaction for a time sufficient for essentially all of the X groups to undergo hydrolysis reactions. Typically the reaction time is from minutes to hours, alternatively 10 minutes to 1 hour. The reaction to produce the silsesquioxane resin can be carried out at any temperature so long as it does not cause significant gellation or cause curing of the silsesquioxane resin. The temperature at which the reaction is carried out is typically in the range of 25 °C up to the reflux temperature of the reaction mixture. Typically the reaction is carried out by heating under reflux for 10 minutes to 1 hour.

The reaction step comprises both hydrolyzing and condensing the silane components. To facilitate the completion of the reaction a catalyst may be used. The catalyst can be a base or an acid such as a mineral acid. Useful mineral acids include, but are not limited to, HCl, HF, HBr, HNO₃, and H₂SO₄, among others, typically HCl. The benefit of HCl or other volatile acids is that a volatile acid can be easily removed from the composition by stripping after the reaction is completed. The amount of catalyst may depend on its nature. The amount of catalyst is typically 0.05 wt% to 1 wt% based on the total weight of the reaction mixture.

Generally, the silane reactants are either not soluble in water or sparingly soluble in water. In light of this, the reaction is carried out in an organic solvent. The organic solvent is present in any amount sufficient to dissolve the silane reactants. Typically the organic solvent is present from 1 to 99 weight percent, alternatively 70 to 90 wt% based on the total weight of the reaction mixture. Useful organic solvents may be exemplified by, but not limited to, saturated aliphatics such as n-pentane, hexane, n-heptane, and isooctane; cycloaliphatics such as cyclopentane and cyclohexane; aromatics such as benzene, toluene, xylene, mesitylene; ethers such as tetrahydrofuran, dioxane, ethylene glycol dietheyl ether, ethylene glycol dimethyl ether; ketones such as methylisobutyl ketone (MIBK) and cyclohexanone; halogen substituted alkanes such as trichloroethane; halogenated aromatics such as bromobenzene and chlorobenzene; esters such as propylene glycol monomethyl ether acetate (PGMEA), isobutyl isobutyrate and propyl propronate. Useful silicone solvents may be exemplified by, but not limited to cyclic siloxanes such as octamethylcyclotetrasiloxane, and decamethylcyclopentasiloxane. A single solvent may be used or a mixture of solvents may be used.

In the process for making the silsesquioxane resin, after the reaction is complete, volatiles may be removed from the silsesquioxane resin solution under reduced pressure. Such volatiles include alcohol by-products, excess water, catalyst, hydrochloric acid (chlorosilanes routes) and solvents. Methods for removing volatiles are known in the art and include, for example, distillation or stripping under reduced pressure.

Following completion of the reaction the catalyst may be optionally removed. Methods for removing the catalyst are well know in the art and would include neutralization, stripping or water washing or combinations thereof. The catalyst may negatively impact the shelf life of the silsesquioxane resin especially when in solution thus its removal is suggested.

To increase the molecular weight of the silsesquioxane resin and/or to improve the storage stability of the silsesquioxane resin the reaction may be carried out for an extended period of time with heating from 40 °C up to the reflux temperature of the solvent ("bodying step"). The bodying step may be carried out subsequent to the reaction step or as part of the reaction step. Typically, the bodying step is carried out for a period of time in the range of 10 minutes to 6 hours, alternatively 20 minutes to 3 hours.

Following the reaction to produce the silsesquioxane resin a number of optional steps may be carried out to obtain the silsesquioxane resin in the desired form. For example, the silsesquioxane resin may be recovered in solid form by removing the solvent. The method of solvent removal is not critical and numerous methods are well known in the art (e.g. distillation under heat and/or vacuum). Once the silsesquioxane resin is recovered in a solid form, the resin can be optionally re-dissolved in the same or another solvent for a particular use. Alternatively, if a different solvent, other than the solvent used in the reaction, is desired for the final product, a solvent exchange may be done by adding a secondary solvent and removing the first solvent through distillation, for example. Additionally, the resin concentration in solvent can be adjusted by removing some of the solvent or adding additional amounts of solvent.

Another method for producing the silsesquioxane resin comprises grafting the corresponding carboxylic acid and/or acid forming group containing monomer onto a starting silsesquioxane resin. The typical method for grafting the corresponding monomer onto the starting silsesquioxane resin is by the hydrosilylation of a carboxy containing olefin onto a Si-H containing silsesquioxane resin in the presence of a transition metal catalyst.

Carboxy containing olefins useful herein include organic molecules that contain a double bond and a carboxy containing group, -COOR³ where R³ is as described above. The carboxy containing group may be exemplified by carboxylic acid (R³ = H), a carboxylic anhydride or a carboxylic ester. When the carboxy containing group is a carboxylic ester group, it has a protected organic group, which may be cleaved under the reaction conditions to yield the corresponding carboxylic acid.

Carboxy containing olefins useful herein include, but are not limited to,

CH₂=CH-(CH₂)_{g}-COOR³

where R³ can be ^{t}Bu, SiMe₃, Si^{t}BuMe₂, or CPh₃; and g = 0 to 8;

CH₂=CH-(CH₂)_{g}-COO-CH₂-OMe

where m = 0 to 8;

CH₂=CH-(CH₂)_{g}-(OCH₂CH₂)ₕ-COOR³

where R can be ^{t}Bu, SiMe₃, Si^{t}BuMe₂, or CPh₃; g = 0 to 8 and h has a value of 1 to 10; or

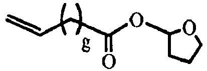

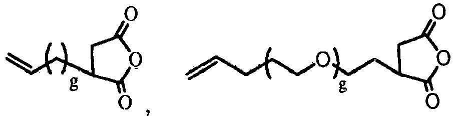

SiH containing silsesquioxane resins useful in the production of the silsesquioxane resins herein are comprised of the units

(Ph(CH₂)ᵣSiO_{(3-x)/2}(OR')ₓ)ₘ

(HSiO_{(3-x)/2}(OR')ₓ)_{n"}

(MeSiO_{(3-x)/2}(OR')ₓ)ₒ

(R¹SiO_{(3-x)/2}(OR')ₓ)_{q}

where Ph is a phenyl group, Me is a methyl group; R' is hydrogen atom or a hydrocarbon group having from 1 to 4 carbon atoms; and R¹ is selected from substituted phenyl groups, ester groups, polyether groups; mercapto groups, sulfur-containing organic functional groups, hydroxyl producing group, aryl sulphonic ester groups, and reactive or curable organic functional groups; and r has a value of 0, 1, 2, 3, or 4; x has a value of 0, 1 or 2; wherein in the resin m has a value of 0 to 0.90; n" has a value of 0.10 to 1; o has a value of 0 to 0.95; q has a value of 0 to 0.5; and m + n" + o + q ≈ 1.

Typically m has a value of 0.05 to 0.25, alternatively 0.05 to 0.15. Typically n" has a value of 0.165 to 0.95, alternatively 0.225 to 0.95. Typically o has a value of 0.25 to 0.80, alternatively 0.25 to 0.75. Typically q has a value of 0 to 0.15, alternatively 0 to 0.1.

The carboxy containing olefin and Si-H containing silsesquioxane resin are reacted in the presence of a transition metal catalyst. Useful transition metal catalysts may be selected from a variety of hydrosilylation catalysts known to promot the reaction of vinyl-functiuonal radicals with silicon-bonded hydrogen atoms. Suitable transition metal catalyst may include platinum and rhodium-containing compounds and complexes. Platinum catalysts such as platinum acetylacetonate or chloroplatinic acid are representative of these compouns and suitable for use. A typical transition metal catalyst is a chloroplatic acid complex of divinyltetramethyldisilxoane diluted in dimethylvinylsiloxy endblocked polydimethylsiloxane.

The amount of carboxy containing olefin to Si-H containing silsesquioxane resin is typically such that the final resin contains 5 to 99 mole % of (HSiO_{(3-x)/2}(OR')ₓ) and 1 to 50 mole % of (RSiO_{(3-x)/2}(OR')ₓ), alternatively 15 to 80 mole % of (HSiO_{(3-x)/2}(OR')ₓ) and 1.5 to 35 mole % of (RSiO_{(3-x)/2}(OR')ₓ), alternatively 20 to 75 mole % of (HSiO_{(3x)/2}(OR')ₓ) and 2.5 to 25 mole % of (RSiO_{(3-x)/2}(OR')ₓ). The amount of transition metal catalyst used is typically present in an amount to provide 2 ppm, alternatively 5 to 200 ppm of transition metal (i.e. Pt) based on the total weight carboxy containing olefin and Si-H containing silsesquioxane.

The silsesquioxane resin is typically applied from a solvent. Useful solvents (ii) include, but are not limited to, 1-methoxy-2-propanol, propylene glycol monomethyl ethyl acetate, gamma-butyrolactone, and cyclohexanone, among others. The ARC composition typically comprises from 10% to 99.9 wt% solvent based on the total weight of the ARC composition, alternatively 80 to 95 wt %.

The antireflective coating compositions are formed by mixing together the silsesquioxane resin, solvent and optionally any other additive.

The antireflective coating is formed on an electronic device by a method comprising
(A) applying to an electronic device an ARC composition comprising
   (i) silsesquioxane resin consisting of the units

      (Ph(CH₂)ᵣSiO_{(3-x)/2}(OR')ₓ)ₘ

      (HSiO_{(3-x)/2}(OR')ₓ)ₙ

      (MeSiO_{(3-x)/2}(OR')ₓ)ₒ

      (RSiO_{(3-x)/2}(OR')ₓ)ₚ

      (R¹SiO_{(3-x)/2}(OR')ₓ)_{q}

      where Ph is a phenyl group, Me is a methyl group; R' is hydrogen atom or a hydrocarbon group having from 1 to 4 carbon atoms; R is according to claim 2; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.90; n has a value of 0.05 to 0.99; o has a value of 0 to 0.95; p has a value of 0.01 to 0.5; q has a value of 0 to 0.5; and m + n + o + p + q ≈ 1; and
   (ii) a solvent, and
(B) removing the solvent and curing the silsesquioxane resin to form an antireflective coating on the electronic device.

The antireflective coating composition is applied to an electronic device to produce a coated substrate. The solvent is removed and the silsesquioxane resin is cured to produce the antireflective coating on the electronic device.

Typically the electronic device is a semiconductor device, such as silicon-based devices and gallium arsenide-based devices intended for use in the manufacture of a semiconductor component. Typically, the device comprises at least one semiconductive layer and a plurality of other layers comprising various conductive, semiconductive, or insulating materials.

Specific methods for application of the ARC composition to the electronic device include, but are not limited to, spin-coating, dip-coating, spay-coating, flow-coating, screenprinting and others. The preferred method for application is spin coating. Typically, coating involves spinning the electronic device, at 1,000 to 2,000 RPM, and adding the ARC composition to the surface of the spinning electronic device.

The solvent is removed and the silsesquioxane resin is cured to form the antireflective coating on the electronic device. Curing generally comprises heating the coating to a sufficient temperature for a sufficient duration to lead to curing. Curing occurs when sufficient crosslinking has taken place such that the silsesquioxane resin is essentially insoluble in the solvent from which it was applied. Curing may take place for example by heating the coated electronic device at 80 °C to 450 °C for 0.1 to 60 minutes, alternatively 150 °C to 275 °C for of 0.5 to 5 minutes, alternatively 200 °C to 250 °C for 0.5 to 2 minutes. Any method of heating may be used during the curing step. For example, the coated electronic device may be placed in a quartz tube furnace, convection oven or allowed to stand on hot plates.

To protect the silsesquioxane resin of the coated composition from reactions with oxygen or carbon during curing, the curing step can be performed under an inert atmosphere. Inert atmospheres useful herein include, but are not limited to nitrogen and argon. By "inert" it is meant that the environment contain less than 50 ppm and alternatively less than 10 ppm of oxygen. The pressure at which the curing and removal steps are carried out is not critical. The curing step is typically carried out at atmospheric pressure although sub or super atmospheric pressures may work also.

Typically the antireflective coating after cure is insoluble in photoresist casting solvents. These solvents include, but are not limted to esters and ethers such at propylene glycol methyl ether acetate (PGMEA) and ethoxy ethyl propionate (EPP). By insoluble it is meant that when the antireflective coating is exposed to the solvent, there is little or no loss in the thickness of the the coating after exposure for 1 minute. Typically the loss in the thickness of the coating is less than 10% of the coating thickness, alternatively less than 7.5% of the coating thickness.

This invention also pertains to a method comprising
(a) forming a antireflective coating on a substrate;
(b) forming a resist coating over the antireflective coating
(c) exposing the resist to radiation;
(d) developing the resist and the antireflective coating;
wherein the antireflective coating is produced from silsesquioxane resin consisting of the units.

(Ph(CH₂)ᵣSiO_{(3-x)/2}(OR')ₓ)ₘ

(HSiO_{(3-x)/2}(OR')ₓ)ₙ

(MeSiO_{(3-x)/2}(OR')ₓ)ₒ

(RSiO_{(3-x)/2}(OR')ₓ)ₚ

(R¹SiO_{(3-x)/2}(OR')ₓ)_{q}

where Ph is a phenyl group, Me is a methyl group; R' is hydrogen atom or a hydrocarbon group having from 1 to 4 carbon atoms; R is according to claim 2; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.90; n has a value of 0.05 to 0.99; o has a value of 0 to 0.95; p has a value of 0.01 to 0.5; q has a value of 0 to 0.5; and m + n + o + p + q ≈ 1.

The antireflective coating is formed as described above. A resist coating is then formed over the antireflective coating. This resist layer can be formed using any known resist materials and method for forming. Typically the resist materials are applied from a solvent solution in a manner similar to producing the antireflective coating herein. The resist coating may be baked to remove any solvent. Depending on the source used for baking, the baking typically occurs by heating the coating to a temperature of 90 °C to 130 °C for several minutes to an hour or more.

After the resist layer is formed it is then exposed to radiation, i.e., UV, X-ray, e-beam, EUV, or the like. Typically ultraviolet radiation having a wavelength of 157 nm to 365 nm is used alternatively ultraviolet radiation having a wavelength of 157 nm or 193 nm is used. Suitable radiation sources include mercury, mercury/xenon, and xenon lamps. The preferred radiation source is a KrF excimer laser (248 nm) or a ArF excimer laser (193 nm). At longer wavelength radiation is used, e.g., 365 nm, it is suggested to add a sensitizer to the photoresist composition to enhance absorption of the radiation. Full exposure of the photoresist composition is typically achieved with less than 100 mJ/cm² of radiation, alternatively with less than 50 mJ/cm² of radiation. Typically the resist layer is exposed through a mask forming a pattern on the coating.

Upon exposure to radiation, the radiation is absorbed by the acid generator in the resist composition to generate free acid. When the resist composition is a positive resist, upon heating, the free acid causes cleavage of acid dissociable groups of the resist. When the resist composition is a negative resist, the free acid causes the crosslinking agents to react with resist, thereby forming insoluble areas of exposed resist. After the resist layer has been exposed to radiation, the resist composition is typically undergoes a post-exposure bake by heating to a temperature in the range of 30 °C to 200 °C, alternatively 75 °C to 150 °C for a short period of time, typically 30 seconds to 5 minutes, alternatively 60 to 90 seconds.

The exposed resist and antireflective coating are removed with a suitable developer or stripper solution to produce an image. Because the antireflective coatings are wet-etchable they may be removed at the same time that the exposed resist is removed, thereby eliminating the need for a separate etch step to remove the antireflective coating. Suitable developer solutions typically contain an aqueous base solution, preferably an aqueous base solution without metal ions, and optionally an organic solvent. One skilled in the art will be able to select the appropriate developer solution. Standard industry developer solutions may be exemplified by, but not limited to organic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and di-n-butyllamine, tertiary amines such as triethylamine and methyldiethylamine, alcoholamines such as dimethylethanolamine and triethanolamine, quaternary ammonium salts such as tetramethylammonium hydroxide, tetraethylammonium hydroxide and choline, and cyclic amines such as pyrrole and piperidine. Typically, solutions of quaternary ammonium salt such as tetramethylammonium hydroxide (TMAH) or choline are used. Suitable fluorided based stripping solutions include but are not limited to NE-89 and CCT-1. After the exposed film has been developed, the remaining resist film ("pattern") is typically washed with water to remove any residual developer solution.

The pattern produced in the resist and antireflective coating layers may then be transferred to the material of the underlying substrate. In coated or bilayer photoresists, this will involve transferring the pattern through the coating that may be present and through the underlayer onto the base layer. In single layer photoresists the transfer will be made directly to the substrate. Typically, the pattern is transferred by etching with reactive ions such as oxygen, plasma, and/or oxygen/sulfurdioxide plasma. Suitable plasma tools include, but are not limited to, electron cyclotron resonance (ECR), helicon, inductively coupled plasma, (ICP) and transmission-coupled plasma (TCP) system. Etching techniques are well known in the art and one skilled in the art will be familiar with the various commercially available etching equipments.

Additional steps or removing the resist film and remaining antireflective coating may be employed to produce a device having the desired architecture.

The antireflective coating compositions of the invention can be used to create patterned material layer structures such as metal wiring lines, holes for contacts or vias, insulation sections (e.g., damascene trenches or shallow trench isolation), trenches for capacitor structures, etc. as might be used in the design of integrated circuit devices. Such processes for making these features are known in the art.

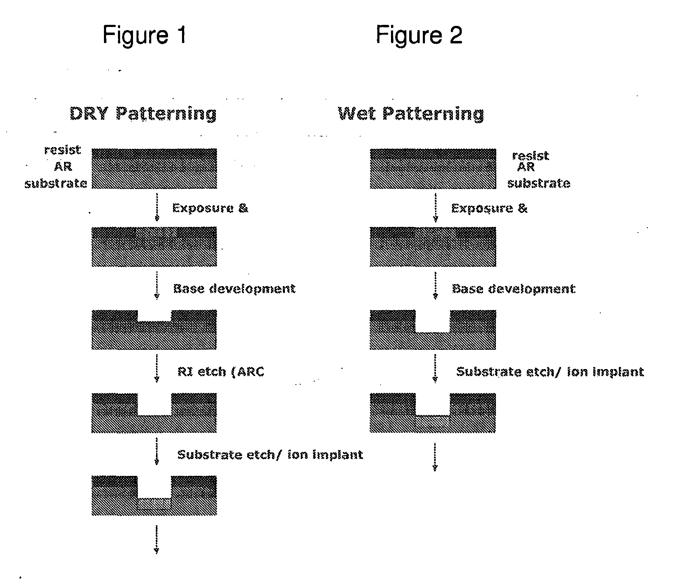

Figure 1 shows the traditional dry patterning process involving an antireflective coating. This process involves forming a resist coating over the antireflective coating. The resist coating is exposed using an exposure device and mask, followed by a post exposure bake (PEB). The resist layer is then developed using a solution of alkali (wet development). The antireflective coating is then removed using typically processes such as RI (etch) to expose the substrate. The substrate is then subjected to typical processes such as substrate etch and/or ion implant.

Figure 2, show a wet patterning process using the antireflective coating described herein. This process involves forming a resist coating over the antireflective coating. The resist coating is exposed using an exposure device, followed by a post exposure bake (PEB). The resist coating and antireflective coating are then simultaneously wet-developed using a base solution. The substrate is then subjected to typical processes such as substrate etch and/or ion implant.

### EXAMPLES

The following examples are included to demonstrate embodiments of the invention. It should be appreciated by those of skill in the art that the techniques disclosed in the examples which follow represent techniques discovered by the inventor to function well in the practice of the invention. However, those of skill in the art should, in light of the present disclosure, appreciate that many changes can be made in the specific embodiments which are disclosed and still obtain a like or similar result without departing from the spirit and scope of the invention. All percentages are in wt. %. Structures given in Examples 1-6 are theoretical structures based on the reactants.

### Example 1

### T^{(Ph)}_{0.10} T^{(H)}_{0.20} T^{(Me)}_{0.625} T^{(PSA)}_{0.075}

A reactor was loaded with 445.1 g of propylene glycol methyl ether acetate (PGMEA), 30.89 g of 3-(triethoxysilyl)propyl succinic anhydride (0.101 mol), 28.62 g of phenyltrichlorosilane (0.135 mol), 126.40 g of methyltrichlorosilane (0.846 mol), and 36.65 g of trichlorosilane (0.271 mol). The jacket temperature was set at 25 °C. The solution was vigorously stirred. To a flask was placed 1080 g of PGMEA and 54.1 g deionized water. The mixture of PGMEA and water was vigorously stirred until all the water dissolved in PGMEA. Next, the PGMEA/water solution was added to the reactor under nitrogen over 1 hour while the reactants were vigorously stirred. After the completion of addition, the mixture in the reactor was washed three times with DI water (2 x 571 g). The solution was then stripped after adding 120 g of Ethanol (EtOH) to give a clear PGMEA solution. The solution is diluted to 10 Wt.% by adding more PGMEA and then filtrated through a 0.2 mm Teflon filter. GPC (vs. polystyrene): Mw =11300, Mw/Mn=2.70.

### Example 2

### T^{(Ph)}_{0.05}T^{(H)}_{0.50}T^{(Me)}_{0.425}T^{(PSA)}_{0.075}

In a reactor was loaded with 672.5 g of propylene glycol methyl ether acetate (PGMEA), 11.42 g of 3-(triethoxysilyl)propyl succinic anhydride (0.038 mol), 15.87 g of phenyltrichlorosilane (0.075 mol), 95.29 g of methyltrichlorosilane (0.638 mol), and 101.59 g of trichlorosilane (0.750 mol). The jacket temperature was set at 25 °C. The solution was vigorously stirred. To a flask was placed 1080 g of PGMEA and 59.4 g deionized water. The mixture of PGMEA and water was vigorously stirred until all the water dissolved in PGMEA. Next, the PGMEA/water solution was added to the reactor under nitrogen over 1 hour while the reactants were vigorously stirred. After the completion of addition, the mixture in the reactor was washed three times with DI water (2 x 500 g). The solution was then stripped after adding EtOH (120 g) to give a clear PGMEA solution. The solution is diluted to 10 Wt.% by adding more PGMEA and then filtrated through a 0.2 mm Teflon filter. GPC (vs. polystyrene): Mw =44300, Mw/Mn=5.99.

### Example 3

### T^{(PhEt)}_{0.07}T^{(H)}_{0.70}T^{(CH}₂^{CHMeCOOtBu)}_{0.23}

To a flask containing hydrosilsesquoxane resin (Mn =2200, 37.10 g, 0.7 mol) in 200 mL of toluene, were added styrene (7.29g, 0.07 mol) and t-butyl methacrylate (32.71 g, 0.23 mol), followed by a platinum catalyst. The mixture was stirred and irradiated with UV lamp at room temperature. After 18 hrs, the volatiles were removed at 40°C to yield the titled resin as viscous oil. The resin was dissolved in PGMEA to give 10 wt.% solution and the solution was filtrated through a 0.2 mm Teflon filter. GPC (vs. polystyrene): Mw =4890, Mw/Mn=2.44;

### Example 4

### T^{(PhEt)}_{0.07}T^{(H)}_{0.74}T^{[(CH}₂⁾₃^{COOtBu)]}_{0.19}

To a flask containing hydrosilsesquoxane resin (Mn =2200, 26.5 g, 0.5 mol) in 200 mL of toluene, were added styrene (3.65 g, 0.035 mol) and t-butyl butenoate (17.0 g, 0.115 mol), followed by a platinum catalyst. The mixture was stirred and refluxed overnight. The volatiles were then removed at 40°C to yield a viscous oil. The oil was dissolved in PGMEA to give 10 wt.% solution and the solution was filtrated through a 0.2 mm Teflon filter. GPC (vs. polystyrene): Mw =5730, Mw/Mn=2.21;

### Example 5

### T^{(PhEt)}_{0.07}T^{(H)}_{0.70}T^{[(CH}₂⁾₃^{COOtBu]}_{0.23}

To a flask containing hydrosilsesquoxane resin (Mn =11,800, 20 g, 0.38 mol) in 100 mL of toluene, were added styrene (3.65 g, 0.035 mol) and t-butyl butenoate (14.22 g, 0.095 mol), followed by a platinum catalyst. The rotary vapor at 40°C to yield viscous oil. The oil was dissolved in PGMEA to give 10 wt.% solution and the solution was filtrated through a 0.2 mm Teflon filter. GPC (vs. polystyrene): Mw =15,300, Mw/Mn=2.78.

### Example 6

### T^{(Ph)}_{0.1}T^{(H)}_{0.2}T^{(Me)}_{0.6}T^{((CH}₂⁾₃^{COOtBu)}_{0.1}

To a flask containing T(Ph)_{0.1}T(H)_{0.3}T(Me)_{0.6} resin (20 g, 0.38 mol) in 100 mL of toluene, were added t-butyl butenoate (3.26 g, 0.022 mol), followed by a platinum catalyst. The mixture was stirred and refluxed overnight. The volatiles were then removed using rotary vapor at 40 °C to yield white solid. The resin was dissolved in PGMEA to give 10 wt.% solution and the solution was filtrated through a 0.2 mm Teflon filter. GPC (vs. polystyrene): Mw =12,450, Mw/Mn=2.95.

### Example 7

The film coating on wafers was processed on a Karl Suss CT62 spin coater. The resin PGMEA solution was first filtered through a 0.2 micron TEFLON filter and then spin coated onto standard single side four inch polished low resistively wafers or double sided polished FTIR wafers (spin speed = 2000 rpm; acceleration speed = 5000, time = 20 seconds unless otherwise indicated). Films were cured at a temperature of 250 °C on a hot plate. PGMEA and TMAH loss after cure was determined by measuring the film thickness change before and after PGMEA or TMAH rinse. Results are given in Table 1

**Table 1. Wet-developable resins as Si-ARC for 193nm Photolithography**

| **Example** | **Resin Composition** | **Th, Å after HPB at 250 C** | **Th, Å STD** | **PGMEA Loss (Å) in 1 min** | **TMAH Loss (Å) in 1min** |
|---|---|---|---|---|---|
| 1 | T^{(Ph)}_{0.10}T^{(H)}_{0.20}T^{(Me)}_{0.625}T^{(PSA)}_{0.075} | 2234 | 6.0 | 1 | |
| | | 2262 | 4.2 | | 2202 |
| 2 | T^{(Ph)}_{0.05}T^{(H)}_{0.50}T^{(Me)}_{0.425}T^{(PSA)}_{0.075} | 2028 | 6.1 | 2 | |
| | | 2028 | 5.2 | | 708 |
| 3 | T^{(PhEt)}_{0.07}T^{(H)}_{0.70}T^{(CH}₂^{CHMeCOOtBu)}_{0.23} | 1487 | 14.1 | 91 | |
| | | 1498 | 14.9 | | 1458 |
| 4 | T^{(PhEt)}_{0.07}T^{(H)}_{0.74}T^{[(CH}₂⁾₃^{COOtBu)]}_{0.19} | 1472 | 11.2 | 2 | |
| | | 1480 | 9.8 | | 1463 |
| 5 | T^{(PhEt)}_{0.07}T^{(H)}_{0.07}T^{[(CH}₂⁾₃^{COOtBu]}_{0.23} | 1787 | 8.65 | 104 | |
| | | 1790 | 10.5 | | 1773 |
| 6 | T^{(Ph)}_{0.1}T^{(H)}_{0.2}T^{(Me)}_{0.6}T^{((CH}₂⁾₃^{COOtBu)}_{0.1} | 2678 | 5.56 | 11 | |
| | | 2699 | 9.43 | | 2678 |

## Claims

1. A method of forming an antireflective coating on an electronic device comprising
(A) applying to an electronic device an antireflective coating composition comprising
(i) carboxy functional silsesquioxane resin consisting of the units
(Ph(CH₂)ᵣSiO_{(3-1)/2}(OR')ₓ)ₘ
(HSiO_{(3-x)/2}(OR')ₓ)ₙ
(MeSiO_{(3-x)/2}(OR')ₓ)ₒ
(RSiO_{(3-x)/2}(OR')ₓ)ₚ
(R¹SiO_{(3-x)/2}(OR')ₓ)_{q}
where Ph is a phenyl group, Me is a methyl group; R' is hydrogen atom or a hydrocarbon group having from 1 to 4 carbon atoms; R is a carboxylic acid-forming group of general formula -R²C(O)OR³ or optionally its mixture with a carboxylic acid group of general formula -R²C(O)OH in which R² is selected from alkylene groups having 1-10 carbon atoms, and R³ is a protecting group, with the proviso that there is a sufficient amount of carboxylic acid groups to make the resin wet developable after cure; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.90; n has a value of 0.05 to 0.99; o has a value of 0 to 0.95; p has a value of 0.01 to 0.5; q has a value of 0 to 0.5; and m + n + o + p + q ≈ 1.; and
(ii) a solvent, and
(B) removing the solvent and curing the silsesquioxane resin to form an antireflective coating on the electronic device.

2. A method comprising
(a) forming a antireflective coating on a substrate;
(b) forming a resist coating over the antireflective coating
(c) exposing the resist to radiation;
(d) developing the resist and the antireflective coating;
wherein the antireflective coating is produced from carboxy functional silsesquioxane resin consisting of the units
(Ph(CH₂)ᵣSiO_{(3-x)/2}(OR')ₓ)ₘ
(HSiO_{(3-x)/2}(OR')ₓ)ₙ
(MeSiO_{(3-x)/2}(OR')ₓ)ₒ
(RSiO_{(3-x)/2}(OR')ₓ)ₚ
(R'SiO_{(3-x)/2}(OR')ₓ)_{q}
where Ph is a phenyl group, Me is a methyl group; R' is hydrogen atom or a hydrocarbon group having from 1 to 4 carbon atoms; R is selected from a carboxylic acid forming group of general formula -R²C(O)OR³ or optionally its mixture with a carboxylic acid group of general formula -R²C(O)OH in which R² is selected from alkylene groups having 1-10 carbon atoms, and R³ is a protecting group, with the proviso that there is a sufficient amount of carboxylic acid groups to make the resin wet developable after cure; and R¹ is selected from substituted phenyl groups, ester groups, mercapto groups, sulfur-containing organic functional groups, aryl sulphonic ester groups, and reactive or curable organic functional groups; and r has a value of 0, 1, 2, 3, or 4; x has a value of 0, 1 or 2; wherein in the resin m has a value of 0 to 0.90; n has a value of 0.05 to 0.99; o has a value of 0 to 0.95; p has a value of 0.01 to 0.5; q has a value of 0 to 0.5; and m + n + o + p + q ≈ 1.

3. The method as claimed in claim 1 or 2 wherein the antireflective coating composition is applied by spin-coating.

4. The method as claimed in claim 1 or 2 wherein the solvent is removed and the silsesquioxane resin is cured by heating at 80°C to 450°C for 0.1 to 60 minutes.

5. The method as claimed in claim 1 wherein the solvent (ii) is selected from 1-methoxy-2-propanol, propylene glycol monomethyl ethyl acetate, gamma-butyrolactone, and cyclohexanone.

6. The method as claimed in claim 1 wherein the solvent is present at 10 to 9.9 wt% based on the total weight of the antireflective coating composition.

7. The method as claimed in claim 1 or 2 wherein the silsesquioxane resin consists of the units (PhSiO_{(3-x)/2}(OR')ₓ)ₘ, (HSiO_{(3-x)/2}(OR')ₓ)ₙ, (MeSiO_{(3x)/2}(OR')ₓ)ₒ, and
(RSiO_{(3-x)/2}(OR')ₓ)ₚ
where Ph is a phenyl group, Me is a methyl group; R' is hydrogen atom or a hydrocarbon group having from 1 to 4 carbon atoms; R is selected from a carboxylic acid forming group of the general formula-R²C(O)OR³ and optionally a carboxylic acid group of general formula-R²C(O)OH in which R² is selected from alkylene groups having 1-10 carbon atoms, and R³ is a protecting group, with the proviso that there is a sufficient amount of carboxylic acid groups to make the resin wet developable after cure; x has a value of 0, 1 or 2; wherein in the resin m has a value of 0.05 to 0.15; n has a value of 0.15 to 0.80; o has a value of 0.25 to 0.80; p has a value of 0.015 to 0.25; and m + n + 0 + p ≈ 1.

8. The method as claimed in claim 1 or 2 wherein the silsesquioxane resin consists of the units (Ph(CH₂)₂SiO_{(3-x)/2}(OR')ₓ)ₘ, (HSiO_{(3-x)/2}(OR')ₓ)ₙ, and (RSiO_{(3-x)/2}(OR')ₓ)ₚ
where Ph is a phenyl group; R' is hydrogen atom or a hydrocarbon group having from 1 to 4 carbon atoms; R is selected from a carboxylic acid forming group of general formula -R²C(O)OR³ and optionally a carboxylic acid group of general formula -R²C(O)OH in which R² is selected from alkylene groups having 1-10 carbon atoms, and R³ is a protecting group, with the proviso that there is a sufficient amount of carboxylic acid groups to make the resin wet developable after cure; x has a value of 0, 1 or 2; wherein in the resin m has a value of 0.05 to 0.15; n has a value of 0.15 to 0.80; p has a value of 0.015 to 0.25; and m + n + p ≈ 1.

9. The method as claimed in claim 1 or 2 wherein R is a mixture of-R²C(O)OH and -R²C(O)OR³.

## Patentansprüche

1. Verfahren zur Ausbildung einer antireflektiven Beschichtung auf einer elektronischen Vorrichtung, umfassend:
(A) das Versehen einer elektronischen Vorrichtung mit einer antireflektiven Beschichtungszusammensetzung, die Folgendes umfasst:
(i) carboxyfunktionales Silsesquioxanharz, das aus den folgenden Einheiten besteht:
(Ph(CH₂)ᵣSiO_{(3-x)/2}(OR')ₓ)ₘ
(HSiO_{(3-x)/2}(OR')ₓ)ₙ
(MeSiO_{(3-x)/2}(OR')ₓ)ₒ
(RSiO_{(3-x)/2}(OR')ₓ)ₚ
(R¹SiO_{(3-x)/2}(OR')ₓ)_{q}
wobei Ph eine Phenylgruppe ist, Me eine Methylgruppe ist; R' ein Wasserstoffatom oder eine Kohlenwasserstoffgruppe ist, die 1 bis 4 Kohlenstoffatome aufweist; R eine carbonsäurebildende Gruppe der allgemeinen Formel -R²C(O)OR³ ist oder optional deren Mischung mit einer Carbonsäuregruppe der allgemeinen Formel -R²C(O)OH ist, in der R² ausgewählt ist aus Alkylengruppen mit 1-10 Kohlenstoffatomen und R³ eine Schutzgruppe ist, mit der Maßgabe, dass eine ausreichende Menge von Carbonsäuregruppen vorhanden sind, damit das Harz nach dem Aushärten nassentwickelt werden kann; und R¹ ausgewählt ist aus substituierten Phenylgruppen, Estergruppen, Mercaptogruppen, schwefelhaltigen organischen funktionellen Gruppen, Arylsulfonestergruppen und reaktiven oder härtbaren organischen funktionellen Gruppen; und r einen Wert von 0, 1, 2, 3 oder 4 hat; x einen Wert von 0, 1 oder 2 hat; wobei in dem Harz m einen Wert von 0 bis 0,90 hat; n einen Wert von 0,05 bis 0,99 hat; o einen Wert von 0 bis 0,95 hat; p einen Wert von 0,01 bis 0,5 hat; q einen Wert von 0 bis 0,5 hat; und m + n + o + p + q ≈ 1.; und
(ii) ein Lösungsmittel, und
(B) Entfernen des Lösungsmittels und Härten des Silsesquioxanharzes, um eine antireflektive Beschichtung auf der elektronischen Vorrichtung auszubilden.

2. Verfahren, umfassend:
(a) das Ausbilden einer antireflektiven Beschichtung auf einem Substrat;
(b) das Ausbilden einer Resistbeschichtung über der antireflektiven Beschichtung;
(c) das Bestrahlen des Resists;
(d) das Entwickeln des Resists und der antireflektiven Beschichtung; wobei die antireflektive Beschichtung aus carboxyfunktionalem Silsesquioxanharz erzeugt wird, das aus folgenden Einheiten besteht:
(Ph(CH₂)ᵣSiO_{(3-x)/2}(OR')ₓ)ₘ
(HSiO_{(3-x)/2}(OR')ₓ)ₙ
(MeSiO_{(3-x)/2}(OR')ₓ)ₒ
(RSiO₍₃₋ₓ₎₂(OR')ₓ)ₚ
(R¹SiO_{(3-x)/2}(OR')ₓ)_{q}
wobei Ph eine Phenylgruppe ist, Me eine Methylgruppe ist; R' ein Wasserstoffatom oder eine Kohlenwasserstoffgruppe ist, die 1 bis 4 Kohlenstoffatome aufweist; R ausgewählt ist aus einer carbonsäurebildenden Gruppe der allgemeinen Formel -R²C(O)OR³ oder optional deren Mischung mit einer Carbonsäuregruppe der allgemeinen Formel -R²C(O)OH, in der R² ausgewählt ist aus Alkylengruppen mit 1-10 Kohlenstoffatomen und R³ eine Schutzgruppe ist, mit der Maßgabe, dass eine ausreichende Menge von Carbonsäuregruppen vorhanden sind, damit das Harz nach dem Aushärten nassentwickelt werden kann; und R¹ ausgewählt ist aus substituierten Phenylgruppen, Estergruppen, Mercaptogruppen, schwefelhaltigen organischen funktionellen Gruppen, Arylsulfonestergruppen und reaktiven oder härtbaren organischen funktionellen Gruppen; und r einen Wert von 0, 1,2, 3 oder 4 hat; x einen Wert von 0, 1 oder 2 hat; wobei in dem Harz m einen Wert von 0 bis 0,90 hat; n einen Wert von 0,05 bis 0,99 hat; o einen Wert von 0 bis 0,95 hat; p einen Wert von 0,01 bis 0,5 hat; q einen Wert von 0 bis 0,5 hat; und m + n + o + p + q ≈ 1.

3. Verfahren nach Anspruch 1 oder 2, wobei die antireflektive Beschichtungszusammensetzung durch Schleuderbeschichten aufgebracht wird.

4. Verfahren nach Anspruch 1 oder 2, wobei durch Erwärmen bei 80 °C bis 450 °C über 0,1 bis 60 Minuten das Lösungsmittel entfernt und das Silsesquioxanharz gehärtet wird.

5. Verfahren nach Anspruch 1, wobei das Lösungsmittel (ii) ausgewählt ist aus 1-Methoxy-2-propanol, Propylenglycolmonomethylethylacetat, gamma-Butyrolacton und Cyclohexanon.

6. Verfahren nach Anspruch 1, wobei das Lösungsmittel, bezogen auf das Gesamtgewicht der antireflektiven Beschichtungszusammensetzung, zu 10 bis 9,9 Gew.-% vorhanden ist.

7. Verfahren nach Anspruch 1 oder 2, wobei das Silsesquioxanharz aus den Einheiten (PhSiO_{(3-x)/2}(OR')ₓ)ₘ, (HSiO_{(3-x)/2}(OR')ₓ)ₙ, (MeSiO_{(3-x)/2}(OR')ₓ)ₒ und (RSiO_{(3-x)/2}(OR')ₓ)ₚ besteht,
wobei Ph eine Phenylgruppe ist, Me eine Methylgruppe ist; R' ein Wasserstoffatom oder eine Kohlenwasserstoffgruppe ist, die 1 bis 4 Kohlenstoffatome aufweist; R ausgewählt ist aus einer carbonsäurebildenden Gruppe der allgemeinen Formel -R²C(O)OR³ und optional einer Carbonsäuregruppe der allgemeinen Formel -R²C(O)OH, in der R² ausgewählt ist aus Alkylengruppen mit 1-10 Kohlenstoffatomen und R³ eine Schutzgruppe ist, mit der Maßgabe, dass eine ausreichende Menge von Carbonsäuregruppen vorhanden ist, damit das Harz nach dem Aushärten nassentwickelt werden kann; x einen Wert von 0, 1 oder 2 aufweist; wobei in dem Harz m einen Wert von 0,05 bis 0,15 hat; n einen Wert von 0,15 bis 0,80 hat; o einen Wert von 0,25 bis 0,80 hat; p einen Wert von 0,015 bis 0,25 hat; und m + n + o + p ≈1.

8. Verfahren nach Anspruch 1 oder 2, wobei das Silsesquioxanharz aus den Einheiten (Ph(CH₂)₂SiO_{(3-x)/2}(OR')ₓ)ₘ, (HSiO_{(3-x)/2}(OR')ₓ)ₙ und (RSiO_{(3-x)/2}(OR')ₓ)ₚ besteht,
wobei Ph eine Phenylgruppe ist; R' ein Wasserstoffatom oder eine Kohlenwasserstoffgruppe ist, die 1 bis 4 Kohlenstoffatome aufweist; R ausgewählt ist aus einer carbonsäurebildenden Gruppe der allgemeinen Formel -R²C(O)OR³ und optional einer Carbonsäuregruppe der allgemeinen Formel -R²C(O)OH, in der R² ausgewählt ist aus Alkylengruppen mit 1-10 Kohlenstoffatomen und R³ eine Schutzgruppe ist, mit der Maßgabe, dass eine ausreichende Menge von Carbonsäuregruppen vorhanden ist, damit das Harz nach dem Aushärten nassentwickelt werden kann; x einen Wert von 0, 1 oder 2 aufweist; wobei in dem Harz m einen Wert von 0,05 bis 0,15 hat; n einen Wert von 0,15 bis 0,80 hat; p einen Wert von 0,015 bis 0,25 hat; und m + n + p ≈ 1.

9. Verfahren nach Anspruch 1 oder 2, wobei R eine Mischung aus -R²C(O)OH und -R²C(O)OR³ ist.

## Revendications

1. Un procédé de formage d'un revêtement antiréfléchissant sur un dispositif électronique comprenant
(A) l'application d'une composition de revêtement antiréfléchissant sur un dispositif électronique comprenant
(i) une résine carboxy fonctionnelle de silsesquioxane constituée de motifs
(Ph(CH₂)ᵣSiO_{(3-x)/2}(OR')ₓ)ₘ
(HSiO_{(3-x)/2}(OR')ₓ)ₙ
(MeSiO_{(3-x)/2}(OR')ₓ)ₒ
(RSiO_{(3-x)/2}(OR')ₓ)ₚ
(R'SiO_{(3-x)/2}(OR')ₓ)_{q}
où Ph est un groupe phényle, Me est un groupe méthyle ; R' est un atome d'hydrogène ou un groupe hydrocarbure ayant de 1 à 4 atomes de carbone ; R est un groupe de formage d'un acide carboxylique de formule générale -R²C(O)OR³ ou facultativement son mélange avec un groupe d'acide carboxylique de formule générale-R²C(O)OH dans lequel R² est choisi parmi des groupes alkylènes ayant de 1 à 10 atomes de carbone, et R³ est un groupe protecteur, à condition que le nombre de groupes d'acide carboxylique soit suffisant pour permettre le développement d'humidité sur la résine après le durcissement ; et R¹ est choisi parmi des groupes phényles substitués, des groupes ester, des groupes mercapto, des groupes fonctionnels organiques contenant du soufre, des groupes ester sulfonique aryle, et des groupes fonctionnels organiques réactifs ou durcissables ; et r a une valeur de 0, 1, 2, 3, ou 4 ; x a une valeur de 0, 1 ou 2 ; où dans la résine m a une valeur allant de 0 à 0,90 ; n a une valeur allant de 0,05 à 0,99 ; o a une valeur allant de 0 à 0,95 ; p a une valeur allant de 0,01 à 0,5 ; q a une valeur allant de 0 à 0,5 ; et m + n + o + p + q ≈ 1. ; et
(ii) un solvant, et
(B) l'élimination du solvant, et le durcissement de la résine silsesquioxane pour former un revêtement antiréfléchissant sur le dispositif électronique.

2. Un procédé comprenant
(a) le formage d'un revêtement antiréfléchissant sur un substrat :
(b) le formage d'un revêtement résistant sur le revêtement antiréfléchissant
(c) l'exposition du revêtement résistant au rayonnement ;
(d) le développement du revêtement antiréfléchissant et du revêtement résistant : où le revêtement antiréfléchissant est produit à partir d'une résine silsesquioxane fonctionnelle constituée de motifs
(Ph(CH₂)ᵣSiO_{(3-x)/2}(OR')ₓ)ₘ
(HSiO_{(3-x)/2}(OR')ₓ)ₙ
(MeSiO_{(3-x)/2}(OR')ₓ)ₒ
(RSiO_{(3-x)/2}(OR')ₓ)ₚ
(R¹SiO_{(3-x)/2}(OR')ₓ)_{q}
où Ph est un groupe phényle, Me est un groupe méthyle ; R' est un atome d'hydrogène ou un groupe hydrocarbure ayant de 1 à 4 atomes de carbone ; R est choisi parmi un groupe de formage d'un acide carboxylique de formule générale -R²C(O)OR³ ou facultativement son mélange avec un groupe d'acide carboxylique de formule générale -R²C(O)OH dans lequel R² est choisi parmi des groupes alkylènes ayant de 1 à 10 atomes de carbone, et R³ est un groupe protecteur, à condition que le nombre de groupes d'acide carboxylique soit suffisant pour permettre le développement d'humidité sur la résine après le durcissement ; et R¹ est choisi parmi des groupes phényles substitués, des groupes ester, des groupes mercapto, des groupes fonctionnels organiques contenant du soufre, des groupes ester sulfonique aryle et des groupes fonctionnels organiques réactifs ou durcissables ; et r a une valeur de 0, 1, 2, 3, ou 4 ; x a une valeur de 0, 1 ou 2 ; où dans la résine m a une valeur allant de 0 à 0,90 ; n a une valeur allant de 0,05 à 0,99 ; o a une valeur allant de 0 à 0,95 ; p a une valeur allant de 0,01 à 0,5 ; q a une valeur allant de 0 à 0,5 ; et m + n + o + p + q ≈1.

3. Le procédé tel que revendiqué dans la revendication 1 ou 2 dans laquelle la composition de revêtement antiréfléchissant est appliquée par revêtement par centrifugation.

4. Le procédé tel que revendiqué dans la revendication 1 ou 2 dans laquelle le solvant est éliminé et la résine silsesquioxane est durcie par chauffage à une température allant de 80 °C à 450 °C pendant 0,1 à 60 minutes.

5. Le procédé tel que revendiqué dans la revendication 1 dans laquelle le solvant (ii) est choisi parmi le 1-methoxy-2-propanol, l'acétate d'éthyle monométhylique de propylène glycol, la gamma-butyrolactone, et la cyclohexanone.

6. Le procédé tel que revendiqué dans la revendication 1 dans laquelle le solvant est présent de 10 à 9,9 % en poids par rapport au poids total de la composition de revêtement antiréfléchissant.

7. Le procédé tel que revendiqué dans la revendication 1 ou 2 dans laquelle la résine silsesquioxane est constituée de motifs (PhSiO_{(3-x)/2}(OR')ₓ)ₘ, (HSiO_{(3-x)/2}(OR')ₓ)ₙ, (MeSiO_{(3-x)/2}(OR')ₓ)ₒ, et
(RSiO_{(3-x)/2}(OR')ₓ)ₚ
où Ph est un groupe phényle, Me est un groupe méthyle ; R' est un atome d'hydrogène ou un groupe hydrocarbure ayant de 1 à 4 atomes de carbone ; R est choisi parmi un groupe de formage d'un acide carboxylique de formule générale - R²C(O)OR³ et facultativement un groupe d'acide carboxylique de formule générale - R²C(O)OH dans lequel R² est choisi parmi des groupes alkylène ayant de 1 à 10 atomes de carbone, et R³ est un groupe protecteur, à condition que le nombre de groupes d'acide carboxylique soit suffisant pour permettre le développement d'humidité sur la résine après le durcissement ; x a une valeur de 0, 1 ou 2 ; où dans la résine m a une valeur allant de 0,05 à 0,15 ; n a une valeur allant de 0,15 à 0,80 ; o a une valeur allant de 0,25 à 0,80 ; p a une valeur allant de 0,015 à 0,25 ; et m + n + o + p ≈1.

8. Le procédé tel que revendiqué dans la revendication 1 ou 2 dans laquelle la résine silsesquioxane est constituée de motifs (Ph(CH₂)₂SiO_{(3-x)/2}(OR')ₓ)ₘ, (HSiO_{(3x)/2}(OR')ₓ)ₙ, et (RSiO_{(3-x)/2}(OR')ₓ)ₚ
où Ph est un groupe phényl ; R' est un atome d'hydrogène ou un groupe hydrocarbure ayant de 1 à 4 atomes de carbone ; R est choisi parmi un groupe de formage d'un acide carboxylique de formule générale -R²C(O)OR³ et facultativement un groupe d'acide carboxylique de formule générale -R²C(O)OH dans lequel R² est choisi parmi des groupes alkylène ayant de 1 à 10 atomes de carbone, et R³ est un groupe protecteur, à condition que le nombre de groupes d'acide carboxylique soit suffisant pour permettre le développement d'humidité sur la résine après le durcissement ; x a une valeur de 0, 1 ou 2 ; où dans la résine m a une valeur allant de 0,05 à 0,15 ; n a une valeur allant de 0,15 à 0,80 ; p a une valeur allant de 0,015 à 0,25 ; et m + n + p ≈ 1.

9. Le procédé tel que revendiqué dans la revendication 1 ou 2 dans laquelle R est un mélange de -R²C(O)OH et -R²C(O)OR³.
